# EUROPÄISCHE PATENTSCHRIFT

(11) **EP 0 645 944 B1**
(45) Veröffentlichungstag und Bekanntmachung des Hinweises auf die Patenterteilung: **29.07.1998**
(21) Anmeldenummer: 94113513.9
(22) Anmeldetag: 30.08.1994
(51) Int. Cl.: H05B 41/00

(54) **Betriebsgerät für elektrische Lampen**
Electric lamp operating device
Appareil d'alimentation de lampes électriques

(30) Priorität: 23.09.1993 DE 9314421 U
(43) Veröffentlichungstag der Anmeldung: 29.03.1995
(73) Patentinhaber: Patent-Treuhand-Gesellschaft für elektrische Glühlampen mbH, 81543 München (DE)
(72) Erfinder: Bernitz, Franz, D-82008 Unterhaching (DE); Niedermeier, Peter, D-80995 München (DE); Osterried, Josef, D-85521 Ottobrunn (DE)

(56) Entgegenhaltungen:
- AT-B- 384 477
- CH-A- 583 497
- DE-A- 2 148 780
- DE-A- 2 539 593

## Beschreibung

Die Erfindung betrifft ein Betriebsgerät für elektrische Lampen gemäß dem Oberbegriff des Schutzanspruchs 1.

Derartige Betriebs geräte werden zum Betrieb von Entladungslampen, insbesondere von niederwattigen Hochdruckentladungslampen mit einer elektrischen Leistungsaufnahme bis ca. 150 Watt, und zum Betrieb von Niedervolt-Halogenglühlampen benötigt. Sie enthalten eine auf die elektrischen Eigenschaften der zu betreibenden Lampe abgestimmte elektrische Schaltung, die auf einer Montageplatine innerhalb eines geschlossenen Gehäuses angeordnet ist. Die handelsüblichen Betriebsgeräte besitzen ein Metall- oder ein Kunststoffgehäuse, wobei die Kunststoffgehäuse in der Regel eine metallische Bodenplatte aufweisen, die als Wärmesenke bzw. zur Wärmeabfuhr dient. Zur besseren Ableitung der von den elektrischen Bauteilen der Schaltung erzeugten Wärme, ist es üblich, das Gehäuse mit einer wärmeleitenden Vergußmasse, die die elektrische Schaltung umgibt, zu füllen.

Üblicherweise wird ein Teil der Vergußmasse in das einseitig offene Gehäuse eingefüllt, dann die Montageplatine mit der elektrischen Schaltung eingelegt und anschließend die restliche Vergußmasse eingegossen. Danach wird das Gehäuse mittels eines Deckels bzw. mittels der metallischen Bodenplatte verschlossen. Nachteilig wirkt sich bei diesem Einfüllverfahren aus, daß hier Luftblasen oder Lufteinschlüsse, insbesondere in der Nähe der metallischen Bodenplatte, in der Vergußmasse entstehen können, die die Wärmeableitung von den elektrischen Bauelementen zum Gehäuse bzw. zur metallischen Bodenplatte beeinträchtigen. Außerdem ist dieses zweistufige Einfüllverfahren vergleichsweise aufwendig.

Es ist die Aufgabe der Erfindung, ein Betriebsgerät für elektrische Lampen bereitzustellen, dessen Gehäuse ein möglichst einfaches Einfüllen von Vergußmasse erlaubt, ohne daß in der Vergußmasse Luftblasen oder Lufteinschlüsse, die die Wärmeableitung von der elektrischen Schaltung zur Gehäusewandung beeinträchtigen, auftreten.

Diese Aufgabe wird erfindungsgemäß durch die kennzeichnenden Merkmale des Schutzanspruchs 1 gelöst. Besonders vorteilhafte Ausführungsformen der Erfindung sind in den Unteransprüchen beschrieben.

Das erfindungsgemäße Betriebsgerät besitzt einen sich in den Innenraum des Gehäuses erstreckenden Einfüllstutzen für die einzufüllende Vergußmasse. Die Montageplatine teilt den Innenraum des Gehäuses in zwei Teilräume, die allerdings untereinander zusammenhängen, so daß die Vergußmasse in einem einzigen Schritt, nachdem die elektrische Schaltung eingesetzt und das Gehäuse bereits verschlossen ist, eingefüllt werden kann. Beim Eingießen der Vergußmasse kann diese sämtliche Hohlräume im Gehäuse und zwischen den elektrischen Bauteilen der Schaltungsanordnung ausfüllen. Die von der Vergußmasse verdrängte Luft kann dabei durch eine Öffnung im Ansatzbereich des Einfüllstutzens entweichen. Auf diese Weise werden Luftblasen oder Lufteinschlüsse in der aushärtenden Vergußmasse vermieden.

Vorteilhafterweise besitzt die Montageplatine einen oder mehrere Aussparungen bzw. Durchbrüche, wobei der Einfüllstutzen sich bis zu einer dieser Aussparungen bzw. bis zu einem dieser Durchbrüche erstreckt, so daß beide durch die Montageplatine definierten Teilraum für die Vergußmasse zugänglich sind. Bei einem besonders bevorzugten Ausführungsbeispiel verläuft die Montageplatine mit der darauf angeordneten elektrischen Schaltung parallel zur metallischen Bodenplatte und der Einfüllstutzen erstreckt sich von der der Bodenplatte gegenüberliegenden Gehäusewandung in den Innenraum des Gehäuses und zwar vorzugsweise bis zu einer Aussparung bzw. bis zu einem Durchbruch in der Montageplatine. Dadurch wird erreicht, daß zunächst der durch die Montageplatine, die Bodenplatte und die Seitenwände des Gehäuses gebildete untere Teilraum vollständig von der Vergußmasse ausgefüllt wird, bevor die Vergußmasse über eine oder mehrere Aussparungen bzw. Durchbrüche in der Montageplatine in den oberen Teilraum eindringt. Es hat sich gezeigt, daß der oberhalb der Montageplatine liegende Teil- bzw. Hohlraum nicht vollständig mit Vergußmasse aufgefüllt werden muß, um eine gute Wärmeableitung von den auf der Montageplatine befindlichen elektrischen Bauteilen zur Bodenplatte zu ermöglichen.

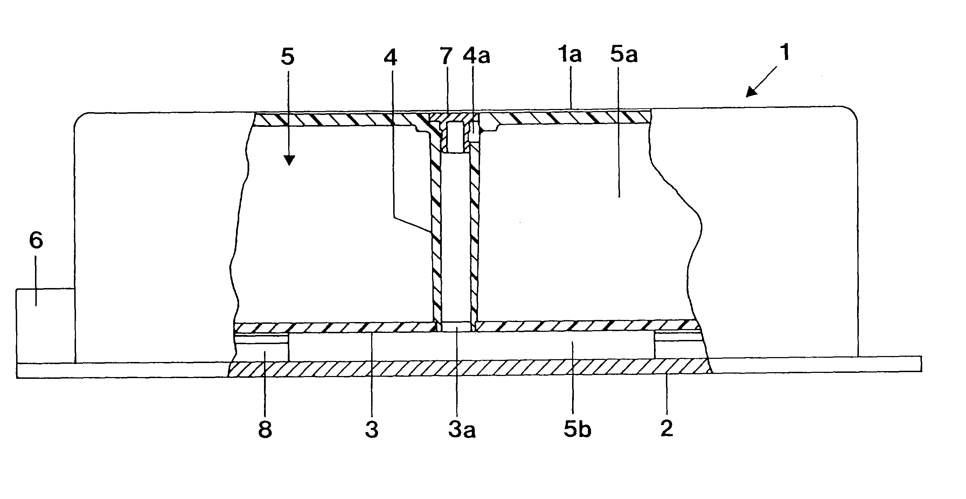

Die Erfindung wird nachstehend anhand eines bevorzugten Ausführungsbeispiels näher erläutert. Die Figur zeigt eine teilweise geschnittene Seitenansicht eines erfindungsgemäßen Betriebsgerätes für elektrische Lampen.

Das Betriebsgerät besteht aus einer elektrischen Schaltung und aus einem geschlossenen Gehäuse 1, das von einer Kunststoffhaube la und einer metallischen Bodenplatte 2 aus Aluminium gebildet wird. Die elektrische Schaltung (nicht abgebildet) ist auf einer vom Gehäuse 1 umschlossenen, parallel zur Bodenplatte 2 verlaufenden Montageplatine 3 angeordnet. Die Montageplatine 3 ist mit der Bodenplatte 2 des Gehäuses 1 verschraubt und besitzt einen zentralen Durchbruch 3a. An die Kunststoffhaube la ist ein rohrartiger, in den Innenraum 5 des Gehäuses 1 hineinragender Einfüllstutzen 4 angeformt. Der Einfüllstutzen 4 verläuft senkrecht zur Bodenplatte 2 und endet im zentralen Durchbruch 3a der Montageplatine 3, dessen Größe paßgerecht auf den Außendurchmesser des Einfüllstutzens 4 abgestimmt ist. Er weist an seiner Ansatzstelle, unmittelbar unterhalb der Kunststoffhaubenwandung, eine Entlüftungsöffnung 4a auf. Die Montageplatine 3 besitzt noch weitere Durchbrüche, über die die beiden Teil- bzw. Hohlräume 5a, 5b des Gehäuseinnenraumes 5 ober- und unterhalb der Montageplatine 3 miteinander in Verbindung stehen. Der Abstand der Montageplatine 3 zur metallischen Bodenplatte 2 mißt ungefähr 0,5 cm. Das Betriebsgerät ist einschließlich der Bodenplatte 2 ca. 4 cm hoch. Die Abmessungen der nahezu quaderförmigen Kunststoffhaube la betragen ca. 11,5 x 8,5 x 3,8 cm³. An einer der Stirnseiten der Kunststoffhaube la befindet sich ein Anschlußteil 6, daß mit der Bodenplatte 2 verschraubt ist und das zum elektrischen Anschluß der Lampe bzw. der Lampen an das Betriebsgerät sowie zur Spannungsversorgung des Betriebsgerätes dient.

Nach der Befestigung der Montageplatine 3, einschließlich der darauf angeordneten elektrischen Bauelemente, auf der Bodenplatte 2 wird die Kunststoffhaube la auf die Bodenplatte 2 aufgesetzt und mittels einer Schnappverbindung 8 an der Montageplatine 3 arretiert, so daß ein geschlossenes Gehäuse 1 entsteht, das die Montageplatine 3 mit den Bauelementen der elektrischen Schaltung umschließt. Danach wird über den Einfüllstutzen 4 ein wärmeleitender, aushärtbarer Epoxidharz in den Innenraum 5 des Gehäuses 1 eingefüllt. Der Epoxidharz füllt dabei zunächst den Hohlraum 5b zwischen der Montageplatine 3 und der Bodenplatte 2 aus und dringt dann über Durchbrüche in der Montageplatine 3 in den Hohlraum 5a oberhalb der Montageplatine 3 ein. Die Füllhöhe des Epoxidharzes beträgt ungefähr 1,5 cm gemessen von der Bodenplatte 2 bzw. ca. 1 cm gemessen von der Montageplatine 3, so daß die maximale Betriebstemperatur innerhalb des Gehäuses 80° Celsius nicht übersteigt. Der Einfüllstutzen 4 wird nach dem Füllvorgang mittels eines Stopfens 7 verschlossen.

Die Erfindung beschränkt sich nicht auf das oben näher beschriebene Ausführungsbeispiel. So kann anstelle des Epoxidharzes auch eine andere Vergußmasse, beispielsweise Polyurethan oder Quarzsand, verwendet werden. Die Füllhöhe der Vergußmasse kann ebenfalls, in Abhängigkeit von der maximal zulässigen Betriebstemperatur, variiert werden. Außerdem ist die Erfindung auf Betriebsgeräte mit einem Gehäuse beliebiger Geometrie anwendbar. Ferner beschränkt sich die Erfindung nicht auf Betriebsgeräte für niederwattige Hochdruckentladungslampen, sondern kann ebenfalls auf Betriebsgeräte von Niederdruckentladungslampen sowie auf Betriebsgeräte von Niedervolt-Halogenglühlampen angewendet werden.

## Patentansprüche

1. Betriebsgerät für elektrische Lampen, bestehend aus einem geschlossenen Gehäuse (1) und aus einer elektrischen Schaltung, wobei das Gehäuse (1) eine metallische Bodenplatte (2) aufweist, die elektrische Schaltung im Innenraum (5) des Gehäuses (1) auf einer Montageplatine (3) montiert ist und das Gehäuse (1) mit einer wärmeleitenden Vergußmasse teilweise oder ganz gefüllt ist, dadurch gekennzeichnet, daß das Betriebsgerät einen rohrartigen, an die Gehäusewandung angesetzten oder angeformten und sich in den Innenraum (5) des Gehäuses (1) erstreckenden Einfüllstutzen (4) für die Vergußmasse besitzt, wobei die durch die Montageplatine (3) gebildeten Teilräume (5a, 5b) des Innenraums (5) untereinander zusammenhängen.

2. Betriebsgerät für elektrische Lampen nach Anspruch 1, dadurch gekennzeichnet, daß die Montageplatine (3) mindestens eine Aussparung oder einen Durchbruch (3a) besitzt, wobei sich der Einfüllstutzen (4) zumindest bis zu der Aussparung bzw. bis zu dem Durchbruch (3a) der Montageplatine (3) erstreckt..

3. Betriebsgerät für elektrische Lampen nach den Ansprüchen 1 und 2, dadurch gekennzeichnet, daß die Montageplatine (3) parallel zur Bodenplatte (2) verläuft und der Einfüllstutzen (4) an der der Bodenplatte (2) gegenüberliegenden Gehäusewandung angesetzt oder angeformt ist.

4. Betriebsgerät für elektrische Lampen nach den Ansprüchen 2 und 3, dadurch gekennzeichnet, daß der Einfüllstutzen (4) sich bis in den durch die Montageplatine (3), die Bodenplatte (2) und die Seitenwände des Gehäuses (1) begrenzten Teilraum (5b) erstreckt.

## Claims

1. Operating device for electric lamps, comprising a closed housing (1) and an electric circuit, the housing (1) having a metallic base plate (2), the electric circuit being mounted in the interior (5) of the housing (1) on a mounting plate (3), and the housing (1) being filled partly or entirely with a heat-conducting casting compound, characterized in that the operating device has a tubular filler stub (4) for the casting compound, which stub is attached to or integrally formed on the housing wall and extends into the interior (5) of the housing (1), the compartments (5a, 5b) of the interior (5) which are formed by the mounting plate (3) being interconnected.

2. Operating device for electric lamps according to Claim 1, characterized in that the mounting plate (3) has at least one cutout or one opening (3a), the filler stub (4) extending at least up to the cutout or up to the opening (3a) in the mounting plate (3).

3. Operating device for electric lamps according to Claims 1 and 2, characterized in that the mounting plate (3) extends parallel to the base plate (2), and the filler stub (4) is attached to or integrally formed on the housing wall opposite the base plate (2).

4. Operating device for electric lamps according to Claims 2 and 3, characterized in that the filler stub (4) extends as far as into the compartment (5b) bounded by the mounting plate (3), the base plate (2) and the side walls of the housing (1).

## Revendications

1. Appareil pour faire fonctionner des lampes électriques, constitué d'un boîtier (1) fermé et d'un circuit électrique, le boîtier (1) comportant une plaque (2) métallique de fond, le circuit électrique étant monté sur une platine (3) de montage à l'intérieur (5) du boîtier (1) et le boîtier (1) étant rempli partiellement ou totalement d'une masse de scellement conductrice de la chaleur, caractérisé en ce que l'appareil pour faire fonctionner des lampes comporte un embout (4) de remplissage de la masse de scellement en forme de tuyau, qui est rattaché à la paroi du boîtier ou qui en est issu et qui s'étend à l'intérieur (5) du boîtier (1), les zones (5a,5b) partielles de l'intérieur (5) formées par la platine (3) de montage communiquant l'une avec l'autre.

2. Appareil pour faire fonctionner des lampes électriques suivant la revendication 1, caractérisé en ce que la platine (3) de montage comporte au moins un évidement ou un perçage (3a), l'embout (4) de remplissage s'étendant au moins jusqu'à l'évidement ou jusqu'au perçage (3a) de la platine (3) de montage.

3. Appareil pour faire fonctionner des lampes électriques suivant les revendications 1 et 2, caractérisé en ce que la platine (3) de montage s'étend parallèlement à la plaque (2) de fond et en ce que l'embout (4) de remplissage est rattaché à la paroi du boîtier faisant face à la plaque (2) de fond ou en est issu.

4. Appareil pour faire fonctionner des lampes électriques suivant les revendications 2 et 3, caractérisé en ce que l'embout (4) de remplissage s'étend jusqu'à la zone (5b) partielle délimitée par la platine (3) de montage, la plaque (2) de fond et les parois latérales du boîtier (1).
